# EUROPÄISCHE PATENTANMELDUNG

(11) **EP 4 564 039 A1**
(43) Veröffentlichungstag der Anmeldung: **04.06.2025**
(21) Anmeldenummer: 23212783.7
(22) Anmeldetag: 28.11.2023
(51) Int. Cl.: G01R 31/55, G01R 31/67

(54) **VERFAHREN ZUM IDENTIFIZIEREN VON ELEKTRISCHEN VERBINDUNGEN, STECKBARES SYSTEM UND KONTAKTTRÄGER**

(71) Anmelder: Murrelektronik GmbH, 71570 Oppenweiler (DE)
(72) Erfinder: LANG, Rudolf, 71570 Oppenweiler (DE); ROEDIGER, Jonny, 71570 Oppenweiler (DE); WOLFF, Ingo, 71570 Oppenweiler (DE)
(74) Vertreter: Prinz & Partner mbB

(57) **Zusammenfassung**

Es ist ein Verfahren zum Identifizieren von elektrischen Verbindungen in steckbaren Systemen (10) gezeigt, wobei das steckbare System (10) zumindest eine elektrische Leitung (24) umfasst, über die ein Versorgungssignal für eine Komponente (12) bereitgestellt wird. Dabei umfasst das Verfahren zumindest die folgenden Schritte:
- Bereitstellen eines Versorgungssignals, das über die elektrische Leitung (24) der Komponente (12) zur Verfügung gestellt wird,
- Modulieren eines Identifikationssignals auf das Versorgungssignal mittels einer Sendestufe (34), um ein Übertragungssignal zu erhalten, das über die elektrische Leitung (24) gesendet wird, wobei das Identifikationssignal eine Information zur Identifikation der elektrischen Verbindung aufweist, und
- Demodulieren des Übertragungssignals mittels einer Empfangsstufe (36), um das Identifikationssignal aus dem Übertragungssignal zu erhalten.

Des Weiteren ist ein steckbares System (10) zum elektrischen Verbinden von zumindest einer Komponente (12) sowie ein Kontaktträger (32) für einen Stecker (20) oder eine Buchse (22) eines steckbaren Systems (10) gezeigt.

## Beschreibung

Die Erfindung betrifft ein Verfahren zum Identifizieren von elektrischen Verbindungen in steckbaren Systemen. Des Weiteren betrifft die Erfindung ein steckbares System zum Herstellen einer elektrischen Verbindung sowie ein Kontaktträger für einen Stecker oder eine Buchse eines steckbaren Systems.

Vor allem in der Industrie, aber auch in anderen Bereichen, werden elektrische Verbindungen immer öfter über Steckverbindungen realisiert, also mittels steckbaren Systemen. Die Beliebtheit der steckbaren Systeme stammt vor allem daher, dass die entsprechenden Steckverbindungen einfach und schnell realisiert werden können. Es könnte also angenommen werden, dass zur Installation auf qualifiziertes Personal verzichtet werden könnte, da entsprechende Leitungen nur zusammengesteckt werden.

Für die steckbaren Systeme werden typischerweise standardisierte Steckverbinder verwendet, wodurch es insbesondere bei der Installation und einer späteren Wartung zu einem Vertauschen der Steckverbindung kommen kann. Dies ist unter anderem der Grund, warum derzeit noch nicht auf qualifiziertes Personal verzichtet werden kann, insbesondere bei einer Wartung.

Um Steckverbindungen zu vermeiden, die nicht auf einen Schaltplan zurückgeführt werden können, d. h. fehlerhaft gesteckte Verbindungen, werden im einfachsten Fall die Stecker mechanisch kodiert. Allerdings ist nicht bei allen Steckern eine Kodierung vorgesehen, sodass es weiterhin zu falschen Steckverbindungen kommen kann.

Als Alternative zu der mechanischen Kodierung ist es bekannt, für den Wartungsfall die Position der Stecker zu fixieren, sodass zumindest während der Wartung die Änderung der Steckverbindung verhindert werden kann, um ein mögliches Abweichen vom Schaltplan zu vermeiden.

Eine weitere Möglichkeit besteht darin, die Leitung elektronisch zu identifizieren, wobei hierzu auf Radio Frequency Identification (RFID)-Technologien zurückgegriffen wird. Dabei werden RFID-Tags an den Steckern über Antennen angesprochen, basierend worauf der jeweilige Stecker identifiziert werden kann. Die Implementierung der RFID-Tags sowie der dazugehörigen Antennen ist jedoch sehr aufwendig und erfordert technisch komplexe Maßnahmen. Insbesondere müssen die Antennen räumlich exakt ausgerichtet sein, um die Positionen der gesteckten Stecker exakt bestimmen zu können. Vor allem bei benachbarten Steckern kann es ansonsten schnell zu einer falschen Identifikation kommen. Der einmalige Installationsaufwand ist also sehr hoch.

Schließlich ist es aus dem Stand der Technik bekannt, nicht den Stecker, sondern die mit dem Stecker verbundene Komponente zu identifizieren. Dazu wird beispielsweise die IO-Link-Technologie verwendet, mit der überprüft werden kann, ob die angeschlossene Komponente die erwartete Seriennummer zurückmeldet. Jedoch ist hierfür ein bestimmter Industrial Communications Network Standard notwendig, der nicht von jeder Komponente erfüllt wird, sodass nicht jede Verbindung überprüft werden kann. Diese Möglichkeit ist also nur begrenzt nutzbar, da die verwendeten Komponenten hinsichtlich des verwendeten Standards eingeschränkt sind. Als Alternative zu der IO-Link-Technologie können auch Profinet-Geräte oder Netzwerkteilnehmer verwendet werden, womit auch eine Identifizierung möglich ist.

Daher ist es die Aufgabe der Erfindung, ein Verfahren sowie ein steckbares System bereitzustellen, welches eine einfache Überprüfung der angeschlossenen Leitungen ermöglicht.

Die Aufgabe wird durch ein Verfahren zum Identifizieren von elektrischen Verbindungen in steckbaren Systemen gelöst, wobei das steckbare System zumindest eine elektrische Leitung umfasst, über die ein Versorgungssignal, beispielsweise eine Versorgungsspannung oder ein Versorgungsstrom, für eine Komponente bereitgestellt wird. Dabei umfasst das Verfahren zumindest die folgenden Schritte:
- Bereitstellen eines Versorgungssignals, das über die elektrische Leitung der Komponente zur Verfügung gestellt wird,
- Modulieren eines Identifikationssignals auf das Versorgungssignal mittels einer Sendestufe, um ein Übertragungssignal zu erhalten, das über die elektrische Leitung gesendet wird, wobei das Identifikationssignal eine Information zur Identifikation der elektrischen Verbindung aufweist, und
- Demodulieren des Übertragungssignals mittels einer Empfangsstufe, um das Identifikationssignal aus dem Übertragungssignal zu erhalten.

In anderen Worten, es wird ein Identifikationssignal auf eine Versorgungsspannung oder einen Versorgungsstrom mittels einer Sendestufe aufmoduliert, wobei das Übertragungssignal, welches das Identifikationssignal umfasst, mittels einer Empfangsstufe demoduliert wird, um das Identifikationssignal zu erhalten. Hierdurch kann die im Identifikationssignal enthaltene Information erhalten und ausgewertet werden. Das Versorgungssignal dient demnach als Trägersignal für die Information des Identifikationssignals.

Die Information, welche durch das Identifikationssignal übermittelt wird, umfasst eine Seriennummer, beispielsweise eine Seriennummer der elektrischen Leitung, des Steckers und/oder der Buchse. Über die entsprechende Information lässt sich also die elektrische Verbindung charakterisieren, insbesondere die elektrische Leitung, der Stecker und/oder die Buchse. Nachfolgend ist unter anderem von einem Steckverbinder die Rede, was sowohl ein Stecker als auch eine Buchse sein kann. Da lediglich die Information wie eine Seriennummer über das auf der Versorgungsspannung aufmodulierte Identifikationssignal übermittelt wird, handelt es sich um eine geringe Datenmenge, welche benötigt wird, um die Information zu übermitteln. Daher ist es möglich, dass die Identifizierung der elektrischen Verbindung auch mit einfachen Kommunikationsstandards erfolgen kann. Hierdurch kann das gesamte System einfacher ausgebildet werden, was wiederum die Kosten senkt, da die Komplexität geringer ist.

Es ist beispielsweise möglich, eine Kommunikation mit nur einer Frequenz zu verwenden, also Kommunikationsstandards, die auf Amplitudenumtastung ("Amplitude-Shift Keying" - ASK) basieren. Außerdem kann die Identifikation auch mit Kommunikationsstandards erfolgen, die auf Frequenzumtastung ("Frequency Shift Keying" - FSK) basieren. Beispielsweise ist somit die Identifikation mit dem Bell 202-Modemstandart möglich. Zudem können Kommunikationsstandards verwendet werden, die auf Phasenumtastung (PSK) basieren.

Selbstverständlich können aber auch komplexere Kommunikationsstandards verwendet werden, die auf komplexeren Modulationsverfahren als ASK, FSK und PSK basieren, beispielsweise Quadraturamplitudenmodulation (QAM) oder Quadraturphasenumtastung (QPSK). Diese Kommunikationsstandards sind jedoch in der Umsetzung aufwendiger und störungsempfindlicher.

Dementsprechend ist, sofern ein einfaches und kostengünstiges System gewünscht ist, ein Kommunikationsstandard bevorzugt, der auf einem vergleichsweise einfachen Modulationsverfahren basiert, beispielsweise ASK, FSK oder PSK.

Bei der elektrischen Leitung kann es sich um eine Versorgungsleitung für die Komponente handeln, da über die elektrische Leitung die Versorgungsspannung bzw. der Versorgungsstrom für die Komponente bereitgestellt wird, also die Energieversorgung der Komponente. Alternativ zu einer Versorgungsleitung kann auch eine Signalleitung verwendet werden, welche die Versorgungsspannung mitführt.

Grundsätzlich kann also eine Spannungsmodulation vorgesehen sein. Als Alternative zur Spannungsmodulation kann auch mit einer definierten Stromquelle moduliert werden, also eine Strommodulation vorgesehen sein.

Die Sendestufe kann durch Hardware realisiert sein, also durch eine Schaltung. Es kann eine analoge Sendestufe vorliegen. Alternativ kann die Sendestufe auch digital ausgebildet sein, beispielsweise zumindest einen GPIO ("General Purpose Input/Output") aufweisen.

Die Empfangsstufe kann diskret oder teil- oder volldigital umgesetzt werden.

Ein Aspekt sieht vor, dass die Sendestufe bzw. die Empfangsstufe ein Zweipol und/oder in einem Stecker bzw. in einer Buchse integriert sein kann, also in einem Steckverbinder. Die Sendestufe und/oder die Empfangsstufe kann also eine Schaltung sein, die zwei Pole bzw. Anschlüsse hat. Dies wird auch als Eintor bezeichnet. Dabei ist die Sendestufe oder die Empfangsstufe insbesondere galvanisch mit einem ersten Potenzial, also über eine Leitung, und kapazitiv mit einem zweiten Potenzial verbunden, beispielsweise über die zwei Anschlüsse. Bei der Leitung, mit der die Sendestufe oder die Empfangsstufe verbunden ist, handelt es sich insbesondere um die elektrische Leitung, also die Leitung, über die das Versorgungssignal bereitgestellt wird. Beim ersten Potenzial handelt es sich beispielsweise um eine (positive) Spannung wie VCC ("Voltage at the Common Collector"), wohingegen es sich beim zweiten Potenzial beispielsweise um die Erdung ("FE" - Funktionserdung) oder Masse (GND - "Ground") handelt. Aufgrund der galvanischen und der kapazitiven Anbindung der jeweiligen Stufe können mögliche Störungen verhindert werden, welche durch das Einbringen der Sende- und/oder Empfangsstufe in die elektrische Verbindung entstehen.

Alternativ zur kapazitiven Anbindung an das zweite Potenzial kann die Sendestufe oder die Empfangsstufe auch mit einer weiteren Leitung galvanisch verbunden sein. Die weitere Leitung kann auch zur Energieversorgung der Komponente dienen, beispielsweise zum Übertragen der Versorgungsspannung, oder zum Übertragen eines anderen Signals.

Die Sendestufe oder die Empfangsstufe kann im Steckverbinder integriert sein, also im Stecker oder in der Buchse. Hierdurch ist eine Identifikation der elektrischen Verbindung möglich, beispielsweise der elektrischen Leitung (samt Stecker oder Buchse), der Komponente (samt Buchse oder Stecker), die mit der elektrischen Leitung verbunden ist, und/oder des Steckverbinders selbst, also des Steckers bzw. der Buchse.

Zudem kann eine Modulationsfrequenz mittels eines Tiefpasses von einem Netzteil entkoppelt werden, über das das Versorgungssignal bereitgestellt wird. Typischerweise sind Netzteile in ihrer Versorgung, insbesondere der Spannungsversorgung, steif, sodass eine Modulation nicht möglich ist. Durch das Einbringen des Tiefpasses, welcher die Modulationsfrequenz von dem vom Netzteil bereitgestellten Versorgungssignal entkoppelt, kann dennoch ein Identifikationssignal auf das Versorgungssignal aufmoduliert werden. Der Tiefpass kann in einer einfachen Ausgestaltung aus einer Spule bestehen.

Die Sendestufe kann einen Generator umfassen, mit dem unterschiedliche Amplituden generiert werden. Der Generator ist beispielsweise dann notwendig, wenn für ein Symbol mehrere Amplituden benötigt werden. Es lassen sich so pro Symbolschritt mehrere Bits kodieren. Werden beispielsweise vier unterschiedliche Amplituden in einem Signal eingesetzt, repräsentieren diese Amplituden jeweils zwei Bits (Symbole: 00, 01, 10 und 11). Dies kann der Fall sein, wenn eine Amplitudenumtastung (ASK) zur Modulation verwendet wird. Letztendlich hängt dies also vom verwendeten Kommunikationsstandard bzw. dem Modulationsverfahren ab, auf dem der Kommunikationsstandard basiert.

Alternativ kann der Generator auch zum On-Off-Keying (OOK) verwendet werden, was die einfachste Form der Amplitudenumtastung ist. Dabei kann eine Trägerfrequenz von dem Generator erzeugt, wodurch die Trägerfrequenz an- bzw. ausgeschaltet werden kann, sodass entsprechend ein Bit (1 oder 0) übertragen werden kann. Bei der Trägerfrequenz handelt es sich um die Frequenz, welche das Identifikationssignal beinhaltet.

Gemäß einer Ausführungsform weist das steckbare System zumindest drei Komponenten auf, die über ein T-Stück miteinander verbunden sind, insbesondere mittels elektrischer Leitungen. Dabei wird ein Arbitrierungsverfahren für die Signale von wenigstens zwei der Komponenten angewandt, um Kollisionen in der Übertragung der Identifikationssignale zu verhindern. Ein solches Arbitrierungsverfahren wird unter anderem auch bei CAN-Anwendungen verwendet. Auch eine bitweise Arbitrierung gemäß des Buszugriffsverfahrens CSMA stellt eine Möglichkeit dar, um Kollisionen in der Übertragung der Identifikationssignale zu verhindern.

Alternative kann für zumindest vier Komponenten auch ein H-Stück für die Verbindung der Komponenten verwendet werden. Prinzipiell können jegliche Abzweigmöglichkeiten für die entsprechende Anzahl an Komponenten verwendet werden.

Es kann also generell ein Abzweig verwendet werden, um mehr als zwei Komponenten miteinander zu verbinden.

Alternativ hierzu können Kollisionen auch zugelassen werden, wobei dann wenigstens ein Identifikationssignal wiederholt ausgesendet wird. Dabei wird durch zufällige Wartezeiten (der jeweiligen Sendestufe) sichergestellt, dass die wenigstens eine Empfangsstufe das entsprechende Identifikationssignal in einer definierten Zeit störungsfrei empfangen kann.

Die Information des Identifikationssignals kann in einer Frequenz, vorzugsweise einer Grundfrequenz, einer Phase und/oder einer Amplitude des Übertragungssignals enthalten sein. Es kann also eine entsprechendes Modulationsverfahren verwendet werden, wodurch die Grundfrequenz des Übertragungssignals, die Oberwelle(n) des Übertragungssignals bzw. die Amplitude des Übertragungssignals entsprechend verändert wird, um die Information des Identifikationssignals zu übertragen. Somit kann sichergestellt werden, dass die Identifikation mithilfe unterschiedlicher Kommunikationsstandards möglich ist.

Bei der Modulationsart kann grundsätzlich eine Rechteckmodulation, eine Sinusmodulation oder andere Modulationsarten verwendet werden.

Gemäß einer Ausführungsform kann die Information des Identifikationssignals, welches aus der Demodulation des Übertragungssignals erhalten worden ist, verarbeitet werden, um die elektrische Verbindung zu identifizieren, insbesondere um die elektrische Leitung, eine mit der elektrischen Leitung verbundene Buchse und/oder einen mit der elektrischen Leitung verbundenen Stecker zu identifizieren, also einen Steckverbinder. Dabei kann eine vollautomatische Identifizierung der elektrischen Verbindung möglich sein. Es wird beispielsweise ein Alarm oder Hinweis ausgegeben, wenn bei der (vollautomatischen) Identifizierung festgestellt wird, dass eine falsch gesteckte elektrische Verbindung vorliegt, also eine elektrische Leitung mit der Komponente verbunden ist, die nicht dafür vorgesehen ist. Insofern wird ein Nutzer darüber informiert, dass die Steckverbindung korrigiert werden sollte.

Außerdem kann die Identifikation kontinuierlich durchgeführt werden, um durchgängig zu überprüfen, ob die elektrischen Verbindungen richtig hergestellt sind, also um korrekte Steckverbindungen zu garantieren.

Auch wird die wird erfindungsgemäß gelöst von einem steckbaren System zum Herstellen einer elektrischen Verbindung. Dabei umfasst das steckbare System eine elektrische Leitung sowie zumindest zwei Komponente mit einem Anschluss, mit dem die elektrische Leitung verbunden ist. Es ist eine Sendestufe vorgesehen, die eingerichtet ist, ein Identifikationssignal auf ein mittels der elektrischen Leitung bereitgestelltes Versorgungssignals zu modulieren, wobei das Identifikationssignal eine Information zur Identifikation der elektrischen Verbindung aufweist. Außerdem weist das steckbare System eine Empfangsstufe auf, die eingerichtet ist, das Übertragungssignal zu demodulieren, um das Identifikationssignal aus dem Übertragungssignal zu erhalten. Somit kann mittels einer geringen Datenmenge eine Information wie eine Seriennummer, welche in dem Identifikationssignal enthalten ist, auf das Versorgungssignal aufmoduliert werden, ohne dass das steckbare System zwangsläufig einen bestimmten Kommunikationsstandard erfüllen muss.

Gemäß einer Ausführungsform weist das steckbare System eine Auswerteeinheit auf, die eingerichtet ist, die Information des Identifikationssignals, welches aus der Demodulation des Übertragungssignals erhalten worden ist, zu verarbeiten, um die elektrische Verbindung zu identifizieren. Somit kann eine automatisierte Überprüfung der Steckverbindung bzw. der elektrischen Verbindung stattfinden, wobei je nach Ergebnis der Auswerteeinheit beispielsweise ein akustisches und/oder optisches Signal ausgegeben werden kann, welches die Richtigkeit der Steckverbindung anzeigt. Es kann auch vorgesehen sein, dass das Signal nur dann ausgegeben wird, wenn eine falsch gesteckte Steckverbindung identifiziert wurde. Dann handelt es sich bei dem Signal um ein Warn- oder Hinweissignal.

Sofern auch bei einer korrekt gesteckten Steckverbindung ein Signal ausgegeben wird, so handelt es sich bei dem Signal um ein Statussignal, was den Status der Steckverbindung ausgibt.

Eine der Komponenten kann ein Sensor oder ein Aktor sein, insbesondere ein nicht-kommunikativer Sensor, beispielsweise eine Lichtschranke oder ein Endschalter, oder ein nicht-kommunikativer Aktor, beispielsweise ein Ventil. Folglich ist eine Überprüfung der Steckverbindung unabhängig von den verwendeten Komponenten möglich, insbesondere auch von Komponenten, die selbst keine Kommunikationsschnittstelle aufweisen.

Daher eignet sich das System auch zum Nachrüsten bei bestehenden Systemen, in denen Komponenten ohne Kommunikationsschnittstelle zum Einsatz kommen.

Gemäß einer Ausführungsform ist die Sendestufe oder die Empfangsstufe als ein Zweipol ausgebildet, wobei die Sendestufe oder die Empfangsstufe galvanisch mit einem ersten Potenzial und kapazitiv mit einem zweiten Potenzial verbunden ist. Somit lassen sich mögliche Störungen, die durch das Einbinden der entsprechenden Stufe auftreten können, wirkungsvoll verhindern.

Die Sendestufe oder die Empfangsstufe des steckbaren Systems kann in einem Stecker oder einer Buchse vorgesehen sein, womit die elektrische Leitung verbunden ist. Somit wird kein separates Bauteil benötigt, um das Identifikationssignal auf das Versorgungssignal aufzumodulieren, sodass das steckbare System weiterhin einfach zu verbinden ist.

Es kann gemäß einer Ausführungsform der Stecker bzw. die Buchse ein kapazitives Anbindungselement für die Sendestufe oder die Empfangsstufe aufweisen. Der Steckverbinder, also der Stecker bzw. die Buchse, weist somit auch das kapazitive Anbindungselement auf, wodurch eine platzsparende Anbindung möglich ist. Beispielsweise kann eine Fläche des Steckverbinders als kapazitives Anbindungselement dienen. Das kapazitive Anbindungselement interagiert dazu mit einem entsprechenden kapazitiven Gegenpart, damit die kapazitive Übertragung möglich ist. Die Sendestufe kann über das kapazitive Anbindungselement das Identifikationssignal übertragen. Die Empfangsstufe kann über das kapazitive Anbindungselement das Übertragungssignal empfangen, das die Information des Identifikationssignals umfasst.

Das kapazitive Anbindungselement kann durch einen Kontaktträger, eine Gewindehülse, ein metallisches Einlegeteil oder eine Beschichtung ausgebildet sein. Somit ist das kapazitive Anbindungselement günstig und einfach herzustellen. Dies liegt insbesondere daran, dass das Versorgungssignal nicht über das kapazitive Anbindungselement übertragen wird, sodass dieses hierfür nicht ausgelegt sein muss. Das kapazitive Anbindungselement muss also keine hohe Stromtragfähigkeit haben, weswegen es in vielfältiger Weise realisiert werden kann.

Außerdem wird die Aufgabe gelöst durch einen Kontaktträger für einen Stecker oder eine Buchse eines steckbaren Systems wie vorstehend beschrieben. Der Kontaktträger weist ein kapazitives Anbindungselement auf. Dabei ist das kapazitive Anbindungselement eingerichtet, kapazitiv mit einem Pol einer als Zweipol ausgebildeten Sendestufe oder Empfangsstufe gekoppelt zu sein, insbesondere wobei das kapazitive Anbindungselement eine metallische Fläche des Kontaktträgers, ein metallisches Einlegeteil, eine leitfähige Beschichtung oder ein 2-Komponenten-Spritzgussteil mit einer leitfähigen Komponente ist. Bei der Fläche kann es sich um eine Fläche einer Gewindehülse handeln. Wie vorstehend schon erläutert, muss das kapazitive Anbindungselement keine hohe Stromtragfähigkeit aufweisen, weswegen dieses grundsätzlich in unterschiedlicher Art und Weise hergestellt sein kann.

Zusätzlich kann das steckbare System einen RFID-Tag, eine mechanische Kodierung und/oder einen IO-Link aufweisen. Es kann demnach ein redundantes System geschaffen werden.

Weitere Merkmale und Vorteile der Erfindung ergeben sich aus der nachfolgenden Beschreibung sowie aus den Zeichnungen, auf die Bezug genommen wird. In den schematischen Zeichnungen zeigen:
- Figur 1 ein erfindungsgemäßes steckbares System gemäß einer beispielhaften Ausführungsform;
- Figur 2 einen Stecker mit einem erfindungsgemäßen Kontaktträger;
- Figur 3 eine schematische Darstellung eines steckbaren Systems gemäß einer ersten Ausführungsvariante;
- Figur 4 eine schematische Darstellung eines steckbaren Systems gemäß einer zweiten Ausführungsvariante;
- Figur 5 eine Übersicht verschiedener Modulationsarten, die beim erfindungsgemäßen Verfahren zum Einsatz kommen können;
- Figur 6 eine schematische Darstellung einer ersten Variante einer Sendestufe eines erfindungsgemäßen Systems;
- Figur 7 eine schematische Darstellung Empfangsstufe eines erfindungsgemäßen Systems;
- Figur 8 eine schematische Darstellung einer zweiten Variante einer Sendestufe eines erfindungsgemäßen Systems; und
- Figur 9 ein Ausgangssignal der Sendestufe aus Figur 8.

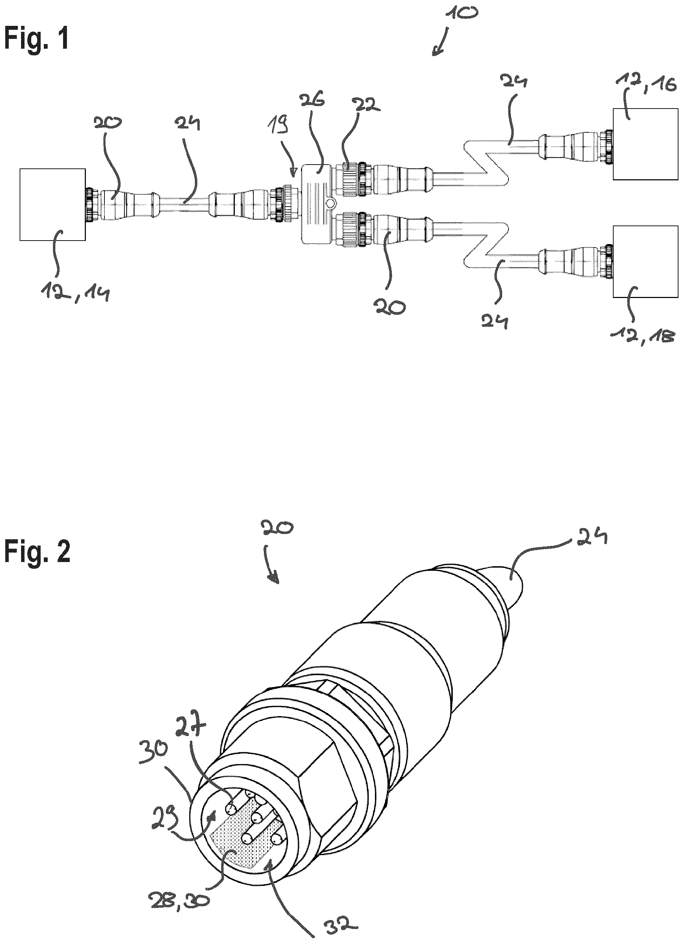

In Figur 1 ist ein steckbares System 10 zu sehen, das zum Herstellen einer elektrischen Verbindung vorgesehen ist, insbesondere mit zumindest einer Komponente 12. In der gezeigten Ausführungsform sind drei Komponenten 12 vorhanden. Grundsätzlich umfasst das steckbare System 10 also zumindest eine Komponente 12, wobei das steckbare System 10 auch mehr, insbesondere mehr als drei, Komponenten 12 umfassen kann.

Bei den Komponenten 12 handelt es sich beispielsweise um einen Master 14, einen Sensor 16 und einen Aktor 18, insbesondere einen nicht-kommunikativen Sensor 16 und/oder einen nicht-kommunikativen Aktor 18. Bei dem Sensor 16 kann es sich um eine Lichtschranke oder einen Endschalter handeln, während der Aktor 18 beispielsweise als ein Ventil ausgeführt ist.

In dem Zusammenhang kann die als Master 14 ausgebildete Komponente 12 als Quelle und die als Sensor 16 oder Aktor 18 ausgebildete Komponente 12 als Senke bezeichnet werden.

Die Komponenten 12 weisen jeweils einen Steckverbinder 19 auf, beispielsweise einen Stecker 20 oder eine Buchse 22, worüber die Komponenten 12 mit einer elektrischen Leitung 24 verbunden sind, an deren Enden auch jeweils ein Steckverbinder 19 vorgesehen ist. Entsprechend dem Anschluss der Komponenten 12, also der Art des Steckverbinders 19 bei der Komponente 12, weist die elektrische Leitung 24 einen korrespondierenden Steckverbinder 19 auf, also eine Buchse 22 bzw. einen Stecker 20.

Mit der ersten Komponente 12, also dem Master 14 bzw. dem Netzteil, kann ein Versorgungssignal bereitgestellt werden, insbesondere für die anderen Komponenten 12, also den Sensor 16 oder den Aktor 18, die mit elektrischen Leitungen 24 angebunden sind.

Wie in der Industrie insbesondere für nicht kommunizierende Komponenten 12 üblich, sind mehrere Komponenten 12, beispielsweise der Master 14 bzw. das Netzteil, der Sensor 16 und der Aktor 18, über ein T-Stück 26 miteinander verbunden.

Das T-Stück 26 dient grundsätzlich dazu, eine elektrische Verbindung aufzuteilen, sodass beispielsweise zwei Komponenten 12 gleichzeitig mit einer bestimmten Komponente 12 verbunden werden können. Vorliegend werden der Sensor 16 und der Aktor 18 mit dem Netzteil bzw. dem Master 14 verbunden. An das T-Stück 26 sind drei elektrische Leitungen 24 angebunden, die jeweils in den entsprechenden Komponenten 12 enden.

In Figur 2 ist eine mögliche Ausführungsform des Steckers 20 zu sehen, der für die Herstellung der elektrischen Verbindung verwendet werden kann, also für die Verbindung der elektrischen Leitung 24 mit einer der Komponenten 12.

Der Stecker 20 weist Kontaktelemente 27, über die eine elektrische Kontaktierung von Kontakten einer Buchse 22 erfolgen kann, um die elektrische Verbindung herzustellen, worüber das Versorgungssignal übertragen wird, beispielsweise die Spannungsversorgung bzw. die Stromversorgung.

Der hier gezeigte Stecker 20 weist neben den Kontaktelementen 27, über die die Energieversorgung der Komponente 12 erfolgen kann, noch ein kapazitives Anbindungselement 28 auf, welches vorliegend durch eine metallische Fläche an einer Innenseite 29 eines kragenförmigen Abschnitts 30 des Steckers 20 ausgebildet ist, der die Kontaktelemente 27 umgibt, also einen Anschlussraum definiert, in dem die Kontaktelemente 27 angeordnet sind.

Insofern ist das kapazitive Anbindungselement 28 den Kontaktelementen 27 zugewandt, aber nicht elektrisch mit diesen verbunden.

Das kapazitive Anbindungselement 28 ist also separat zu den Kontaktelementen 27 ausgebildet, sodass die elektrische Verbindung nicht über das kapazitive Anbindungselement 28 erfolgt. Mit anderen Worten wird das Versorgungssignal nicht über das kapazitive Anbindungselement 28 übertragen.

Das kapazitive Anbindungselement 28 kann an einer Fläche eines Kontaktträgers 32 des Steckers 20 ausgebildet sein.

Alternativ zu der metallischen Fläche kann das kapazitive Anbindungselement 28 durch ein metallisches Einlegeteil, eine leitfähige Beschichtung oder ein 2-Komponenten-Spritzgussteil mit einer leitfähigen Komponente ausgebildet sein.

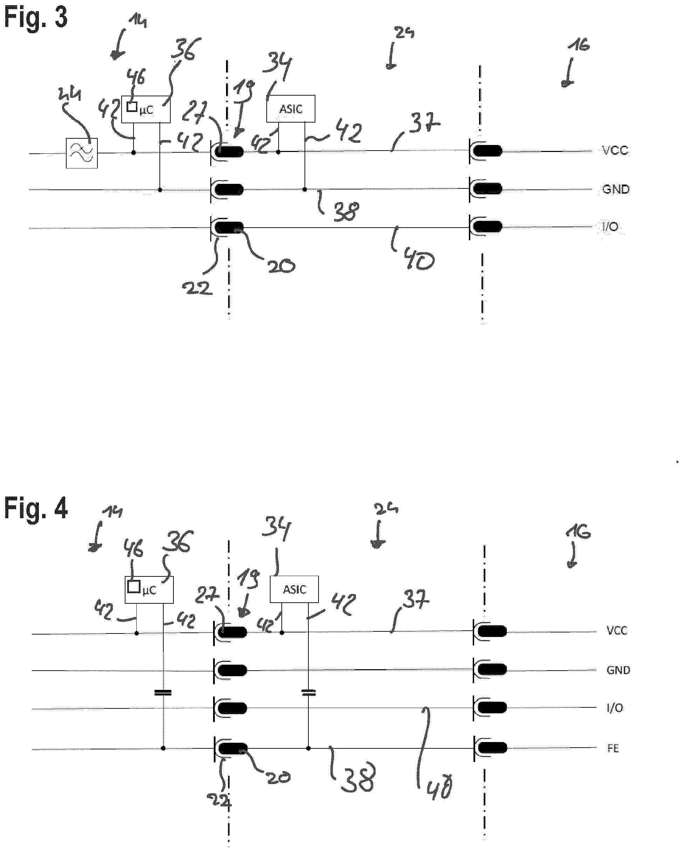

Zur Funktionsweise des kapazitiven Anbindungselements 28 wird nachfolgend auf die Figuren 3 und 4 verwiesen, in denen schematische Darstellungen des steckbaren Systems 10 gezeigt sind.

Grundsätzlich weist das steckbare System 10 eine Sendestufe 34 sowie eine Empfangsstufe 36 auf.

In der gezeigten Ausführungsform ist die Sendestufe 34 in der elektrischen Leitung 24 vorgesehen, insbesondere im jeweiligen Steckverbinder 19, welche die erste Komponente 12, also den Master 14, mit der zweiten Komponente 12 verbindet, also den Sensor 16. Vorliegend ist die Sendestufe 34 als eine anwendungsspezifische integrierte Schaltung (ASIC) ausgebildet.

Die Empfangsstufe 36 ist dagegen in der ersten Komponente 12, nämlich dem Master 14 bzw. dem Netzteil, angeordnet, insbesondere im jeweiligen Steckverbinder 19. Zudem ist die Empfangsstufe 36 als Mikrocontroller ausgebildet.

Grundsätzlich kann die Position, die Anordnung und/oder die Ausbildung der Sendestufe 34 und/oder der Empfangsstufe 36 auch anders sein.

In jedem Fall kann mit der Sendestufe 34 ein Identifikationssignal auf ein mittels der elektrischen Leitung 24 bereitgestelltes Versorgungssignal aufmoduliert werden, also auf eine Versorgungsspannung oder einen Versorgungsstrom, was mit der elektrischen Leitung 24 an die angeschlossene Komponente 12 übertragen wird.

Vorliegend wird beispielsweise das Versorgungssignal von der ersten Komponente 12, nämlich dem Master 14 bzw. dem Netzteil, an die zweite Komponente 12 übertragen, nämlich dem Sensor 16.

Selbstverständlich kann auch der Aktor 18 anstelle des Sensors 16 vorgesehen sein.

Mit dem Identifikationssignal, insbesondere der im Identifikationssignal enthaltenen Information, kann die elektrische Verbindung identifiziert werden, wie nachfolgend noch erläutert wird.

In Figur 3 ist gezeigt, dass die Sendestufe 34 und die Empfangsstufe 36 jeweils als Zweipol ausgebildet sind, also zwei Anschlüsse/Pole aufweisen, worüber die die Sendestufe 34 und die Empfangsstufe 36 jeweils mit einen ersten Potenzial 37 (vorliegend: "VCC") und einem zweiten Potenzial 38 (vorliegend: "GND") verbunden sind. Sowohl "VCC" als auch "GND" stellen dabei die Versorgungspotenziale dar, um die Komponente 12 mit einer Spannung zu versorgen.

Zusätzlich kann die elektrische Verbindung noch eine I/O-Leitung 40 aufweisen, worüber beispielsweise Ansteuerungs- oder Sensorsignale übermittelt werden können, also Kommunikationssignale.

Wie aus Figur 3 hervorgeht, sind sowohl die Sendestufe 34 als auch die Empfangsstufe 36 galvanisch mit den Leitungen verbunden, welche dem ersten Potenzial 37 ("VCC") und den zweiten Potenzial 38 ("GND") zugeordnet sind, also über Leiter 42.

Insofern sind die Sendestufe 34 und die Empfangsstufe 36 separat zur I/O-Leitung 40 angebunden, worüber die Kommunikationssignale übertragen werden, sodass das Identifikationssignal nicht über die Kommunikationsleitung übertragen wird, also nicht über die I/O-Leitung 40.

Wie bereits erwähnt, wird für die Identifizierung der elektrischen Verbindung von der Sendestufe 34 das Identifikationssignal auf das Versorgungssignal moduliert, um das Übertragungssignal zu erhalten.

Die Empfangsstufe 36 ist wiederum eingerichtet, das Übertragungssignal zu demodulieren, um das Identifikationssignal aus dem Übertragungssignal zu erhalten, insbesondere die Information.

Das Identifikationssignal umfasst die Information, insbesondere eine Seriennummer, der elektrischen Leitung 24, des Steckers 20 und/oder der Buchse 22.

Da lediglich eine Information wie eine Seriennummer zur Identifikation benötigt wird, werden nur sehr geringe Datenmengen übertragen, sodass die Modulation auf einfachen Kommunikationsstandards beruhen kann.

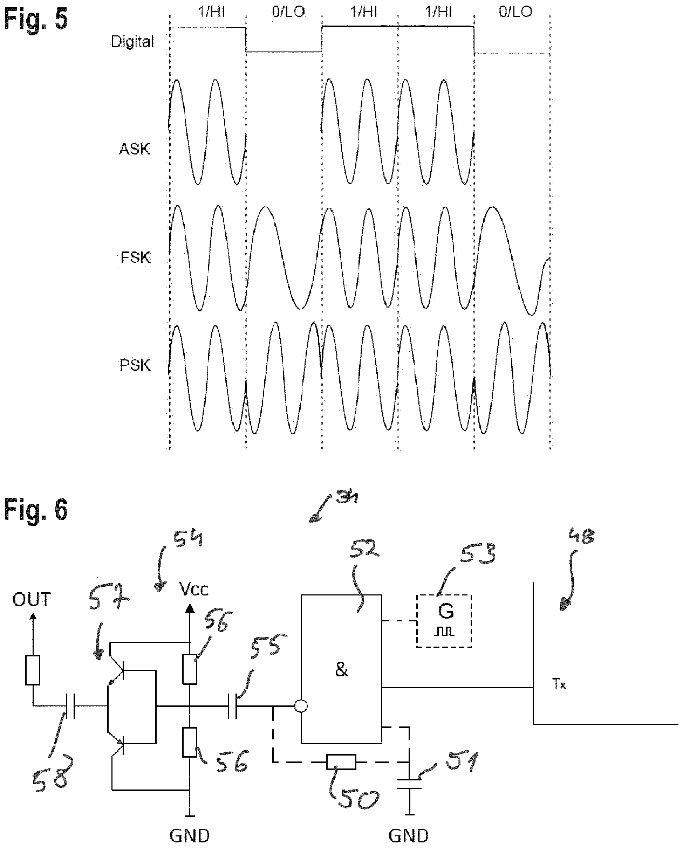

Es reicht beispielsweise für die Identifikation der elektrischen Verbindung aus, wenn die Modulation auf einer Amplitudenumtastung (ASK) beruht. Eine entsprechende Sendestufe 34 ist beispielsweise in Figur 6 dargestellt, worauf später eingegangen wird.

Anstatt der Amplitudenumtastung können auch Kommunikationsstandards verwendet werden, die auf Frequenzumtastung (FSK) basieren, beispielsweise der Bell-202-Modemstandart. Auch die Phasenumtastung (PSK) stellt eine Modulation dar, worauf ein entsprechender Kommunikationsstandard basieren kann, um das Identifikationssignal auf das Versorgungssignal zu modulieren.

In Figur 5 ist eine Übersicht gängiger Modulationsarten gezeigt. Aus der Übersicht gehen die Unterschiede zwischen den einzelnen Modulationsarten hervor. Bei den dargestellten Modulationsarten handelt es sich um Amplituden-, Frequenz- und Phasenumtastung.

Es können aber auch komplexere Modulationsverfahren wie die Quadraturamplitudenmodulation (QAM) oder die Quadraturphasenumtastung (QPSK) verwendet werden.

In Abhängigkeit des Modulationsverfahrens kann die Information des Identifikationssignals in einer Frequenz, einer Phase und/oder einer Amplitude des Übertragungssignals enthalten sein.

Damit ein Modulationsverfahren in jedem Fall möglich ist, insbesondere unabhängig vom verwendeten Netzteil zur Energieversorgung, kann außerdem ein optionaler Tiefpass 44 vorgesehen sein, welcher dazu dient, die Modulationsfrequenz zu entkoppeln. Viele Netzteile würden eine Modulation auf dem Versorgungssignal, beispielsweise der Versorgungsspannung, nicht zulassen. Durch das Entkoppeln der Modulationsfrequenz kann diese Einschränkung jedoch umgangen werden. Der Tiefpass 44 kann aus einer einfachen Spule bestehen, sodass die Konstruktion schnell, einfach und günstig ist.

Das Einbringen der Sendestufe 34 oder der Empfangsstufe 36 in die elektrische Verbindung kann zu unvorhersehbaren Störungen, insbesondere Störungen der Komponente(n) 12 sowie der Kommunikation führen.

Insofern kann vorgesehen sein, dass die Sendestufe 34 und die Empfangsstufe 36 als zweites Potenzial 38 mit einer Funktionserdung ("FE") in kapazitiver Weise verbunden sind. "GND" stellt dann nur noch das zweite Versorgungspotenzial dar. Dies ist schematisch in Figur 4 gezeigt.

Die kapazitive Verbindung mit der Funktionserdung ("FE"), welche in Figur 4 gezeigt ist, kann über das kapazitive Anbindungselement 28 erfolgen, was in Figur 2 für den Stecker 20 gezeigt ist. Die Buchse 22 kann ebenfalls ein kapazitives Anbindungselement 28 aufweisen.

Die kapazitive Verbindung kann für die Sendestufe 34 und/oder die Empfangsstufe 36 vorgesehen sein. Es ist also nicht zwingend erforderlich, dass beide Stufen 34, 36 gleichzeitig kapazitiv angebunden sind, wie dies in Figur 4 gezeigt ist. Vielmehr kann auch nur eine der Stufen 34, 36 mit dem zweiten Potenzial 38 kapazitiv gekoppelt sein, wohingegen die andere Stufe galvanisch mit dem zweiten Potenzial 38 verbunden ist.

Grundsätzlich umfasst das System 10 eine Auswerteeinheit 46, die eingerichtet ist, die Information des Identifikationssignals, welches aus der Demodulation des Übertragungssignals erhalten worden ist, zu verarbeiten, um die elektrische Verbindung zu identifizieren.

Vorliegend ist die Auswerteeinheit 46 in der Empfangsstufe 36 implementiert, nämlich im Mikrocontroller.

Mit der Auswerteeinheit 46 kann eine automatisierte Überprüfung der hergestellten Steckverbindung erfolgen, also der elektrischen Verbindung. Je nach Ergebnis der Überprüfung kann dann ein akustisches und/oder optisches Signal ausgegeben werden. Beispielsweise ist vorgesehen, dass das Signal nur dann ausgegeben wird, wenn eine falsch gesteckte Steckverbindung durch die Auswerteeinheit 46 identifiziert wurde. Alternativ kann dauerhaft ein Signal in Form eines Statussignals ausgegeben werden, sodass der Zustand bzw. der Status der elektrischen Verbindung kontinuierlich erfasst und ausgegeben wird.

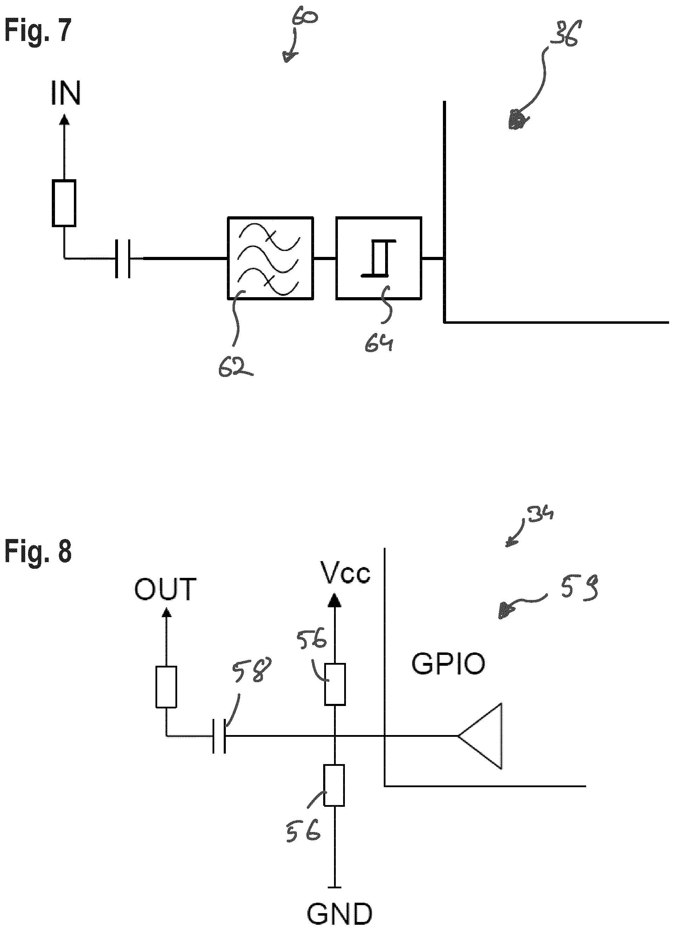

In den Figuren 6 und 8 sind zwei verschiedene Varianten der Sendestufe 34 gezeigt. Die genaue Ausführung der Sendestufe 34 ist abhängig von der Modulationsart, die verwendet wird, um ein Identifizierungssignal auf das Versorgungssignal aufzumodulieren, das über die elektrische Leitung 24 der Komponente 12 zur Verfügung gestellt wird.

Die in Figur 6 gezeigte Sendestufe 34 ist durch Hardware realisiert, also durch eine Schaltung, wobei das Funktionsprinzip der Amplitudenumtastung als Modulationsverfahren vorgesehen ist. Grundsätzlich können die Komponenten der Sendestufe 34 in einem integrierten Baustein umgesetzt sein. Insofern dient die Darstellung der Figur 6 dazu, das Funktionsprinzip zu erläutern.

In der Sendestufe 34 wird das Identifikationssignal auf das Versorgungsignal aufmoduliert. Hierbei wird das Identifikationssignal durch einen Sender 48 der Sendestufe 34 bereitgestellt.

Die Sendestufe 34 umfasst hierzu einen Widerstand 50 und einen Kondensator 51, womit die Frequenz der Sendestufe 34 eingestellt werden kann, also die des Identifikationssignals. Zudem weist die Sendestufe 34 ein UND-Glied 52 auf, das auch als UND-Gatter bezeichnet werden kann. Die Frequenz ergibt sich dabei aus der Dimensionierung des Widerstands 50 in Bezug auf den Kondensator 51 sowie der Laufzeit des UND-Glieds 52.

Wenn an dem UND-Glied 52 ein HIGH-Signal anliegt, entsteht durch eine Rückkopplung ein Rechteckgenerator.

Durch die Verwendung eines optionalen Generators 53 (gestrichelt dargestellt in Figur 6) kann eine höhere Präzision in der Trägerfrequenz erzeugt werden. Der Generator 53 kann anstelle des Widerstands 50 und des Kondensators 51 verwendet werden, weshalb die entsprechend zugeordneten Leiter ebenfalls gestrichelt dargestellt sind.

Die Sendestufe 34 weist zudem einen Sender 48 auf. Der Sender 48 generiert die Information des Identifikationssignals über einen Universal Asynchronous Receiver/Transmitter (UART). Hierbei wird ein serielle Bit-Sequenz erzeugt, welche im Identifikationssignal codiert ist.

Das UND-Glied 52 moduliert die vom Sender 48 erhaltene Bit-Sequenz bei einem HIGH-Signal auf die Frequenz des Identifikationssignals auf, die als Trägerfrequenz für die Information dient. Sowohl die Trägerfrequenz als auch das Identifikationssignal sind dann am Ausgang des UND-Glieds 52 als Rechteck ausgebildet.

Darüber hinaus umfasst die Sendestufe 34 einen Hochpass 54, der sich an das UND-Glied 52 anschließt und einen Kondensator 55 des Hochpasses 54 sowie zwei Widerstände 56 des Hochpasses 54 umfasst. Der Hochpass 54 erzeugt eine Sinusspannung mit einem Offset, bevorzugt ein Offset von ½ des ersten Potenzials 37 ("VCC").

Anschließend wird über eine Transistor-Schaltung 57, welche eine Treiberstufe bildet, die Sinusspannung über einen Ausgangs-Kondensator 58 auf die Versorgungsspannung aufmoduliert, also das von der Sendestufe 34 erzeugte Identifikationssignal, das an einem Ausgang der Sendestufe 34 vorliegt.

Eine alternative Sendestufe 34 ist in Figur 8 gezeigt, wobei diese Sendestufe 34 einen General Purpose Input/Output-Generator ("GPIO") 59 aufweist, der die analoge Schaltung der in Figur 6 gezeigten Sendestufe 34 ersetzt. Der GPIO 59 ist mit dem Ausgang verbunden, sodass unter anderem auf den das UND-Glied 52 sowie die Transistorschaltung 57 verzichtet werden kann. Zudem kann auf den Widerstand 50 mit dem Kondensator 51 bzw. den Generator 53 verzichtet werden.

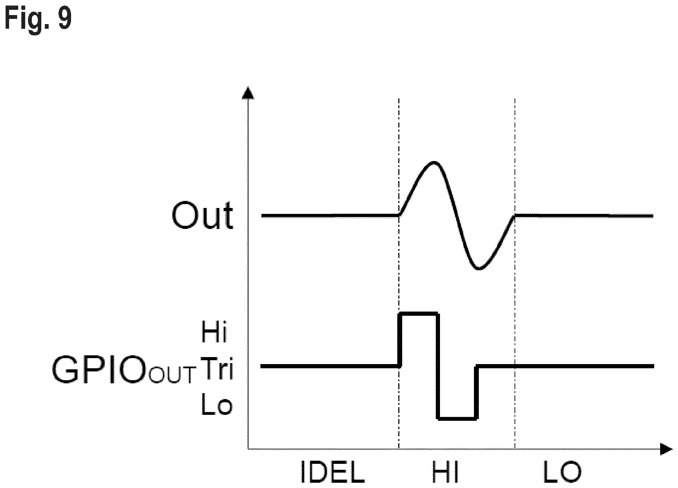

Ein Beispiel eines Ausgangssignals der in Figur 8 gezeigten Sendestufe 34 ist in Figur 9 zu sehen, zusammen mit dem Signal des GPIOs 59.

Wie bereits erläutert, muss das Übertragungssignal anschließend wieder demoduliert werden, um die elektrische Verbindung identifizieren zu können. Dies geschieht in der Empfangsstufe 36, die in Figur 7 in einer beispielhaften Ausführung für eine Amplitudenumtastung zu sehen ist.

An einem Eingang 60 der Empfangsstufe 36 befindet sich ein Filter 62, insbesondere ein Bandpass bzw. Bandbreitenfilter. Alternativ kann die Empfangsstufe 36 anstelle des Bandpass auch einen Hochpass aufweisen.

Nachdem das Übertragungssignal den Filter 62 passiert hat, findet die Umwandlung des Übertragungssignals zu einem diskreten Signal statt, um das Identifikationssignal zu erhalten. Dies kann, wie in Figur 7 gezeigt, über einen Schmitt-Trigger 64 erfolgen. Es kann aber auch ein Komparator oder ein andersartiger Schwellenwertschalter vorgesehen sein.

Grundsätzlich kann die Empfangsstufe 36 diskret, teil- oder volldigital umgesetzt werden, wie schon in Bezug auf den Mikrocontroller dargestellt.

Das Identifikationssignal, welches aus dem Übertragungssignal erhalten worden ist, kann anschließend beispielsweise von der Auswerteeinheit 46 verarbeitet werden, um die elektrische Verbindung zu identifizieren.

Wenn zumindest zwei Komponenten 12, wie in Figur 1 gezeigt, über das T-Stück 26 miteinander verbunden sind, kann es grundsätzlich zu Kollisionen der jeweiligen Identifikationssignale bzw. Übertragungssignale kommen. Um dies zu vermeiden, kann ein Arbitrierungsverfahren verwendet werden.

Als Alternative hierzu können Kollisionen zugelassen werden, wobei die Identifikationssignale wiederholt mit zufälligen Wartezeiten von den unterschiedlichen Sendestufen 34 gesendet werden, sodass jedes Identifikationssignal bzw. Übertragungssignal von der Empfangsstufe 36 in einer definierten Zeit störungsfrei empfangen werden kann.

Das steckbare System 10 kann zusätzlich einen RFID-Tag, eine mechanische Kodierung und/oder einen IO-Link aufweisen, welche das vorhergehend beschriebene Verfahren ergänzen.

**Bezugszeichen**

| | |
|---|---|
| 10 | steckbares System |
| 12 | Komponente |
| 14 | Master |
| 16 | Sensor |
| 18 | Aktor |
| 19 | Steckverbinder |
| 20 | Stecker |
| 22 | Buchse |
| 24 | elektrische Leitung |
| 26 | T-Stück |
| 28 | kapazitives Anbindungselement |
| 29 | Innenseite |
| 30 | kragenförmiger Abschnitt |
| 32 | Kontaktträger |
| 34 | Sendestufe |
| 36 | Empfangsstufe |
| 37 | erstes Potenzial |
| 38 | zweites Potenzial |
| 40 | I/O-Leitung |
| 42 | Leiter |
| 44 | Tiefpass |
| 46 | Auswerteeinheit |
| 48 | Sender |
| 50 | Widerstand |
| 51 | Kondensator |
| 52 | UND-Glied |
| 53 | Generator |
| 54 | Hochpass |
| 55 | Kondensator des Hochpasses |
| 56 | Widerstand des Hochpasses |
| 57 | Transistorschaltung |
| 58 | Ausgangs-Kondensator |
| 59 | General Purpose Input/Output-Generator |
| 60 | Eingang |
| 62 | Filter |
| 64 | Schmitt-Trigger |

## Patentansprüche

1. Verfahren zum Identifizieren von elektrischen Verbindungen in steckbaren Systemen (10), wobei das steckbare System (10) zumindest eine elektrische Leitung (24) umfasst, über die ein Versorgungssignal für eine Komponente (12) bereitgestellt wird, und wobei das Verfahren zumindest folgende Schritte umfasst:
- Bereitstellen eines Versorgungssignals, das über die elektrische Leitung (24) der Komponente (12) zur Verfügung gestellt wird,
- Modulieren eines Identifikationssignals auf das Versorgungssignal mittels einer Sendestufe (34), um ein Übertragungssignal zu erhalten, das über die elektrische Leitung (24) gesendet wird, wobei das Identifikationssignal eine Information zur Identifikation der elektrischen Verbindung aufweist, und
- Demodulieren des Übertragungssignals mittels einer Empfangsstufe (36), um das Identifikationssignal aus dem Übertragungssignal zu erhalten.

2. Verfahren nach Anspruch 1, **dadurch gekennzeichnet, dass** die Sendestufe (34) ein Zweipol ist und/oder in einem Stecker (20) oder in einer Buchse (22) integriert ist, insbesondere wobei die Sendestufe (34) galvanisch mit einem ersten Potenzial (37) und kapazitiv oder galvanisch mit einem zweiten Potenzial (38) verbunden ist.

3. Verfahren nach einem der Ansprüche 1 und 2, **dadurch gekennzeichnet, dass** die Empfangsstufe (36) ein Zweipol ist und/oder in einem Stecker (20) oder in einer Buchse (22) integriert ist, insbesondere wobei die Empfangsstufe (36) galvanisch mit einem ersten Potenzial (37) und kapazitiv oder galvanisch mit einem zweiten Potenzial (38) verbunden ist.

4. Verfahren nach einem der vorhergehenden Ansprüche, **dadurch gekennzeichnet, dass** eine Modulationsfrequenz mittels eines Tiefpasses (44) von einem Netzteil entkoppelt wird, über das das Versorgungssignal bereitgestellt wird.

5. Verfahren nach einem der vorhergehenden Ansprüche, **dadurch gekennzeichnet, dass** das steckbare System (10) zumindest drei Komponenten (12) aufweist, die über ein T-Stück (26) miteinander verbunden sind, wobei ein Arbitrierungsverfahren für die Signale von wenigstens zwei der Komponenten (12) angewandt wird, um Kollisionen in der Übertragung der Identifikationssignale zu verhindern.

6. Verfahren nach einem der vorhergehenden Ansprüche, **dadurch gekennzeichnet, dass** die Information des Identifikationssignals in einer Frequenz, einer Phase und/oder einer Amplitude des Übertragungssignals enthalten ist.

7. Verfahren nach einem der vorhergehenden Ansprüche, **dadurch gekennzeichnet, dass** die Information des Identifikationssignals, welches aus der Demodulation des Übertragungssignals erhalten worden ist, verarbeitet wird, um die elektrische Verbindung zu identifizieren, insbesondere die elektrische Leitung (24), eine mit der elektrischen Leitung (24) verbundene Buchse (22) und/oder ein mit der elektrischen Leitung (24) verbundener Stecker (20).

8. Steckbares System (10) zum Herstellen einer elektrischen Verbindung, umfassend eine elektrische Leitung (24) sowie zumindest zwei Komponenten (12) mit jeweils einem Anschluss, mit dem die elektrische Leitung (24) verbunden ist, wobei eine Sendestufe (34) vorgesehen ist, die eingerichtet ist, ein Identifikationssignal auf ein mittels der elektrischen Leitung (24) bereitgestelltes Versorgungssignals zu modulieren, wobei das Identifikationssignal eine Information zur Identifikation der elektrischen Verbindung aufweist, und wobei das steckbare System (10) eine Empfangsstufe (36) aufweist, die eingerichtet ist, das Übertragungssignal zu demodulieren, um das Identifikationssignal aus dem Übertragungssignal zu erhalten.

9. Steckbares System (10) nach Anspruch 8, **dadurch gekennzeichnet, dass** das steckbare System (10) eine Auswerteeinheit (46) aufweist, die eingerichtet ist, die Information des Identifikationssignals, welches aus der Demodulation des Übertragungssignals erhalten worden ist, zu verarbeiten, um die elektrische Verbindung zu identifizieren.

10. Steckbares System (10) nach Anspruch 8 oder 9, **dadurch gekennzeichnet, dass** eine der Komponenten (12) ein Sensor (16) oder ein Aktor (18) ist, insbesondere ein nicht-kommunikativer Sensor oder ein nicht-kommunikativer Aktor.

11. Steckbares System (10) nach einem der Ansprüche 8 bis 10, **dadurch gekennzeichnet, dass** die Sendestufe (34) und/oder die Empfangsstufe (36) als ein Zweipol ausgebildet sind bzw. ist, wobei die Sendestufe (34) und/oder die Empfangsstufe (36) galvanisch mit einem ersten Potenzial (37) und kapazitiv oder galvanisch mit einem zweiten Potenzial (38) verbunden sind bzw. ist.

12. Steckbares System (10) nach einem der Ansprüche 8 bis 11, **dadurch gekennzeichnet, dass** die Sendestufe (34) oder die Empfangsstufe (36) in einem Stecker (20) oder einer Buchse (22) vorgesehen ist, womit die elektrische Leitung (24) verbunden ist.

13. Steckbares System (10) nach Anspruch 12, **dadurch gekennzeichnet, dass** der Stecker (20) bzw. die Buchse (22) ein kapazitives Anbindungselement (28) für die Sendestufe (34) oder die Empfangsstufe (36) aufweist.

14. Steckbares System (10) nach Anspruch 13, **dadurch gekennzeichnet, dass** das kapazitive Anbindungselement (28) durch einen Kontaktträger (32), eine Gewindehülse, ein metallisches Einlegeteil oder einer Beschichtung ausgebildet ist.

15. Kontaktträger (32) für einen Stecker (20) oder eine Buchse (22) eines steckbaren Systems (10) nach einem der Ansprüche 8 bis 14, wobei der Kontaktträger (32) ein kapazitives Anbindungselement (28) aufweist, und wobei das kapazitive Anbindungselement (28) eingerichtet ist, kapazitiv mit einem Pol einer als Zweipol ausgebildeten Sendestufe (34) oder Empfangsstufe (36) gekoppelt zu sein, insbesondere wobei das kapazitive Anbindungselement (28) eine metallische Fläche des Kontaktträgers (32), ein metallisches Einlegeteil, eine leitfähige Beschichtung oder ein 2-Komponenten-Spritzgussteil mit einer leitfähigen Komponente ist.

## Geänderte Patentansprüche

### Geänderte Patentansprüche gemäss Regel 137(2) EPÜ.

1. Verfahren zum Identifizieren von elektrischen Verbindungen in steckbaren Systemen (10), wobei das steckbare System (10) zumindest eine elektrische Leitung (24) umfasst, über die ein Versorgungssignal für eine Komponente (12) bereitgestellt wird, wobei die elektrische Leitung (24) mit einem Stecker (20) und/oder einer Buchse (22) verbunden ist, und wobei das Verfahren zumindest folgende Schritte umfasst:
- Bereitstellen eines Versorgungssignals, das über die elektrische Leitung (24) der Komponente (12) zur Verfügung gestellt wird,
- Modulieren eines Identifikationssignals auf das Versorgungssignal mittels einer Sendestufe (34), die in dem Stecker (20) oder in der Buchse (22) integriert ist, um ein Übertragungssignal zu erhalten, das über die elektrische Leitung (24) gesendet wird, wobei das Identifikationssignal eine Information zur Identifikation der elektrischen Verbindung aufweist, und
- Demodulieren des Übertragungssignals mittels einer Empfangsstufe (36), um das Identifikationssignal aus dem Übertragungssignal zu erhalten, um die elektrische Verbindung zu identifizieren, also die elektrische Leitung (24), die mit der elektrischen Leitung (24) verbundene Buchse (22) und/oder den mit der elektrischen Leitung (24) verbundenen Stecker (20).

2. Verfahren nach Anspruch 1, **dadurch gekennzeichnet, dass** die Sendestufe (34) ein Zweipol ist.

3. Verfahren nach einem der Ansprüche 1 bis 2, **dadurch gekennzeichnet, dass** die Sendestufe (34) galvanisch mit einem ersten Potenzial (37) und kapazitiv oder galvanisch mit einem zweiten Potenzial (38) verbunden ist.

4. Verfahren nach einem der vorhergehenden Ansprüche, **dadurch gekennzeichnet, dass** die Empfangsstufe (36) ein Zweipol ist.

5. Verfahren nach einem der vorhergehenden Ansprüche, **dadurch gekennzeichnet, dass** die Empfangsstufe (36) galvanisch mit einem ersten Potenzial (37) und kapazitiv oder galvanisch mit einem zweiten Potenzial (38) verbunden ist.

6. Verfahren nach einem der vorhergehenden Ansprüche, **dadurch gekennzeichnet, dass** eine Modulationsfrequenz mittels eines Tiefpasses (44) von einem Netzteil entkoppelt wird, über das das Versorgungssignal bereitgestellt wird.

7. Verfahren nach einem der vorhergehenden Ansprüche, **dadurch gekennzeichnet, dass** das steckbare System (10) zumindest drei Komponenten (12) aufweist, die über ein T-Stück (26) miteinander verbunden sind, wobei ein Arbitrierungsverfahren für die Signale von wenigstens zwei der Komponenten (12) angewandt wird, um Kollisionen in der Übertragung der Identifikationssignale zu verhindern.

8. Verfahren nach einem der vorhergehenden Ansprüche, **dadurch gekennzeichnet, dass** die Information des Identifikationssignals in einer Frequenz, einer Phase und/oder einer Amplitude des Übertragungssignals enthalten ist.

9. Steckbares System (10) zum Herstellen einer elektrischen Verbindung, umfassend eine elektrische Leitung (24) sowie zumindest zwei Komponenten (12) mit jeweils einem Anschluss, mit dem die elektrische Leitung (24) verbunden ist, wobei eine Sendestufe (34) in einem Stecker (20) oder einer Buchse (22) vorgesehen ist, womit die elektrische Leitung (24) verbunden ist, wobei die Sendestufe (34) eingerichtet ist, ein Identifikationssignal auf ein mittels der elektrischen Leitung (24) bereitgestelltes Versorgungssignals zu modulieren, wobei das Identifikationssignal eine Information zur Identifikation der elektrischen Verbindung aufweist, wobei das steckbare System (10) eine Empfangsstufe (36) aufweist, die eingerichtet ist, das Übertragungssignal zu demodulieren, um das Identifikationssignal aus dem Übertragungssignal zu erhalten, und wobei das steckbare System (10) eine Auswerteeinheit (46) aufweist, die eingerichtet ist, die Information des Identifikationssignals, welches aus der Demodulation des Übertragungssignals erhalten worden ist, zu verarbeiten, um die elektrische Verbindung zu identifizieren, also die elektrische Leitung (24), die mit der elektrischen Leitung (24) verbundene Buchse (22) und/oder den mit der elektrischen Leitung (24) verbundenen Stecker (20),.

10. Steckbares System (10) nach Anspruch 9, **dadurch gekennzeichnet, dass** eine der Komponenten (12) ein Sensor (16) oder ein Aktor (18) ist, insbesondere ein nicht-kommunikativer Sensor oder ein nichtkommunikativer Aktor.

11. Steckbares System (10) nach einem der Ansprüche 9 bis 10, **dadurch gekennzeichnet, dass** die Sendestufe (34) und/oder die Empfangsstufe (36) als ein Zweipol ausgebildet sind bzw. ist, wobei die Sendestufe (34) und/oder die Empfangsstufe (36) galvanisch mit einem ersten Potenzial (37) und kapazitiv oder galvanisch mit einem zweiten Potenzial (38) verbunden sind bzw. ist.

12. Steckbares System (10) nach einem der Ansprüche 9 bis 11, **dadurch gekennzeichnet, dass** die Empfangsstufe (36) in dem Stecker (20) oder der Buchse (22) vorgesehen ist, womit die elektrische Leitung (24) verbunden ist, und wobei der Stecker (20) bzw. die Buchse (22) ein kapazitives Anbindungselement (28) für die Empfangsstufe (36) aufweist.

13. Steckbares System (10) nach einem der Ansprüche 7 bis 10, **dadurch gekennzeichnet, dass** der Stecker (20) bzw. die Buchse (22) ein kapazitives Anbindungselement (28) für die Sendestufe (34) aufweist.

14. Steckbares System (10) nach Anspruch 12 oder 13, **dadurch gekennzeichnet, dass** das kapazitive Anbindungselement (28) durch einen Kontaktträger (32), eine Gewindehülse, ein metallisches Einlegeteil oder einer Beschichtung ausgebildet ist.

15. Verwendung eines Kontaktträgers (32) in einem Stecker (20) oder einer Buchse (22) eines steckbaren Systems (10) nach einem der Ansprüche 9 bis 14, wobei der Kontaktträger (32) ein kapazitives Anbindungselement (28) aufweist, und wobei das kapazitive Anbindungselement (28) eingerichtet ist, kapazitiv mit einem Pol einer als Zweipol ausgebildeten Sendestufe (34) oder Empfangsstufe (36) gekoppelt zu sein, insbesondere wobei das kapazitive Anbindungselement (28) eine metallische Fläche des Kontaktträgers (32), ein metallisches Einlegeteil, eine leitfähige Beschichtung oder ein 2-Komponenten-Spritzgussteil mit einer leitfähigen Komponente ist.
